# EUROPEAN PATENT APPLICATION

(11) **EP 2 450 971 A2**
(43) Date of publication of application: **09.05.2012**
(21) Application number: 11188241.1
(22) Date of filing: 08.11.2011
(51) Int. Cl.: H01L 33/00, H01L 33/08, H01L 33/06

(54) **Solid state light emitting device and method for making the same**

(30) Priority: 09.11.2010 TW 099138489
(71) Applicant: Lextar Electronics Corp., 30075 Hsinchu (TW)
(72) Inventor: Chen, Ming-Sheng, Changhua County (TW); Liang, Wen-Teng, Hsinchu (TW)
(74) Representative: Cohausz & Florack

(57) **Abstract**

A method for making a solid state light emitting device includes: (a) forming a first cladding layer (42) on a substrate (41); (b) forming a matrix layer (431) above the first cladding layer (42), the matrix layer (431) having a top surface and being formed with a plurality of isolated spaces (434); (c) epitaxially forming a quantum cluster (432) in each of the spaces (434) such that the top surface of the matrix layer (431) and top surfaces of the quantum clusters (432) cooperatively define a coplanar surface (4301), the quantum clusters (432) cooperating with the matrix layer (431) to form a light emitting layer (430); (d) forming a second cladding layer (44) on the light emitting layer (430); and (e) forming an electrode unit (45) electrically connected to the first and second cladding layers (42, 44).

## Description

This application claims priority of Taiwanese application No. 099138489, filed on November 9, 2010.

This invention relates to a solid state light emitting device and a method for making the same, more particularly to a solid state light emitting device including a structure of quantum clusters and a method for making the same.

Solid state light emitting devices, especially light emitting diodes, have been widely applied in various fields, and, for example, can be used in a back module of a display, traffic signs, and lighting. Especially, a light emitting diode (LED) which is environmentally friendly and which has the advantage of energy conservation is quickly replacing traditional mercury lamps and incandescent lamps. In order to improve the applications of light emitting diodes, it is desired in the art to increase luminous brightness and efficiency of the light emitting diodes.

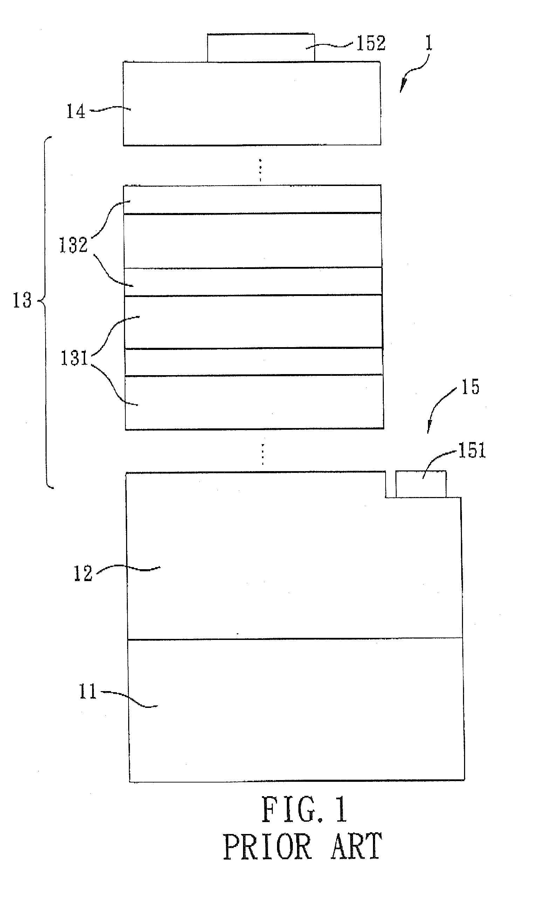

Referring to Fig. 1, a conventional light emitting diode 1 includes a sapphire substrate 11, a n-type cladding layer 12 composed of a n-type semiconductor material, a p-type cladding layer 14 composed of a p-type semiconductor material, a light emitting unit 13 disposed between the n-type and p-type cladding layers 12, 14, and an electrode unit 15 connected to the n-type and p-type cladding layers 12, 14 and electrically connected to an external circuit. The light emitting unit 13 includes a plurality of barrier layers 131 and a plurality of active layers 132 that are alternately disposed. The active layers 132 have a structure of quantum well. The electrode unit 15 includes a first electrode 151 connected to the n-type cladding layer 12 and a second electrode 152 connected to the p-type cladding layer 14.

When the electrode unit 15 is connected to the external circuit and then provides electricity to the light emitting unit 13, the carriers, i.e., electrons and holes, from the n-type and p-type cladding layers 12, 14 are able to recombine with each other within the active layers 132 of the light emitting unit 13 such that the active layers 132 may release energy in the form of photons according to electroluminescence effect.

However, the internal quantum efficiency of the active layers 132 of the light emitting diode 1 is limited and relatively low because the quantum well structures of the active layers 132 are a two-dimensional structure where the carriers are relatively free to move therein and thus may stay at various energy states. Moreover, after manufacture, the dislocation densities of the n-type cladding layer 12, the light emitting unit 13, and the p-type cladding layer 14 are relatively high that may adversely influence the recombination of the carriers, thereby reducing the luminous efficiency of the light emitting diode 1.

In order to overcome the aforesaid drawbacks that the luminous efficiency of the conventional light emitting diode 1 cannot be effectively improved, light emitting diodes with a quantum-dot-like structure have been proposed.

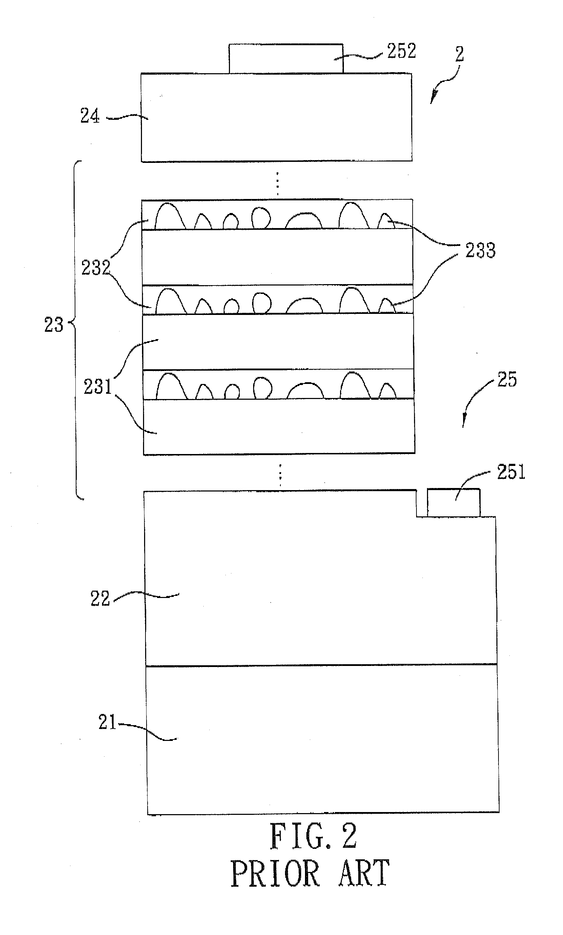

Referring to Fig. 2, a conventional light emitting diode 2 with a quantum-dot-like structure includes a sapphire-based substrate 21, a n-type cladding layer 22 that is composed of a n-type semiconductor material and that is formed on the sapphire-based substrate 21, a p-type cladding layer 24 composed of a p-type semiconductor material, a light emitting unit 23 disposed between the n-type and the p-type cladding layers 22, 24, and an electrode unit 25 electrically connected to an external circuit. The light emitting unit 23 includes a plurality of barrier layers 231 and a plurality of active layers 232 that are alternately disposed. The active layers 232 have a quantum-dot-like structure 233 and may release energy in the form of photons according to electroluminescence effect. The electrode unit 25 includes a first electrode 251 connected to the n-type cladding layer 22 and a second electrode 252 connected to the p-type cladding layer 24.

When the electrode unit 25 is connected to the external circuit and then provides electricity to the light emitting unit 23, the carriers, i. e. , electrons and holes, from the n-type and p-type cladding layers 22, 24 are limited and recombine with each other in the quantum-dot-like structure 233 of the active layers 132 and release energy in the form of photons.

Since the quantum-dot-like structure 233 of the active layers 232 is a quasi-zero-dimensional structure that confines the carriers, i.e., electrons and holes from the n-type and p-type cladding layers 22, 24, in all three dimensions, the space that the carriers can freely move is relatively reduced. In addition, the quantum-dot-like structure 233 is hardly influenced by the dislocations of the n-type cladding layer 22, the light emitting unit 23, and the p-type cladding layer 24. Therefore, recombination of the electrons and holes is enhanced and the electricity is effectively transferred into photon energy, thereby improving the luminous efficiency of the light emitting diode 2.

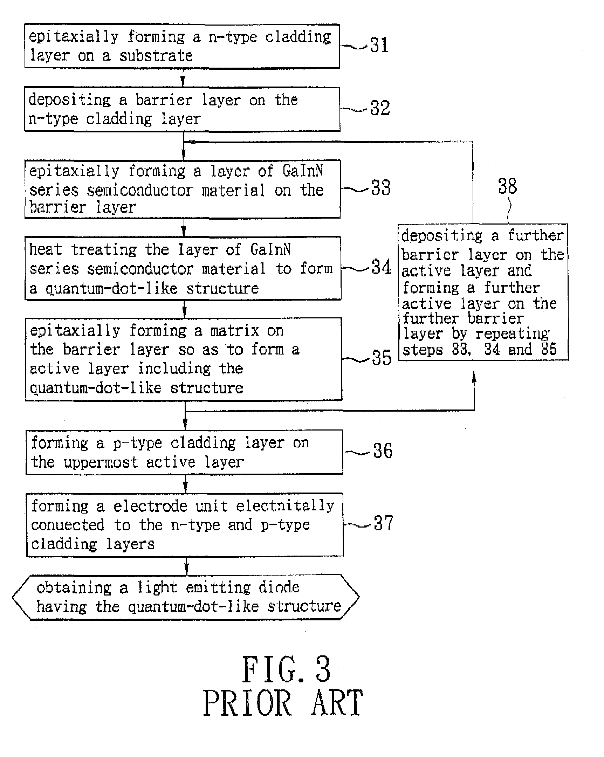

Referring to Figs. 2 and 3, generally, the light emitting diode 2 having the quantum-dot-like structure 233 is manufactured by epitaxially forming the n-type cladding layer 22 on the substrate 21 (step 31), depositing the barrier layer 231 on the n-type cladding layer 22 (step 32) , epitaxially forming a layer of GaInN series semiconductor material on the barrier layer 231 (step 33), subsequently heat treating the layer of GaInN series semiconductor material to form the quantum-dot-like structure 233 at random on the barrier layer 231 (step 34), epitaxially forming a matrix layer on the barrier layer 231 so as to form the active layer 232 including the quantum-dot-like structure 233 (step 35), depositing the further barrier layer 231 on the active layer 232 and forming the further active layer 232 on the further barrier layer 231 by repeating steps 33 to 35such that the active layers 232 and the barrier layers 231 are alternately disposed, forming the p-type cladding layer 24 on the uppermost active layer 232 (step 36), and forming the first and second electrodes 251, 252 on the n-type and p-type cladding layers 22, 24, respectively, to form the electrode unit 25 (step 37). The light emitting diode 2 having the quantum-dot-like structure 233 is thus obtained.

In view of the aforesaid, although the luminous efficiency of the light emitting diode 2 with the quantum-dot-like structure 233 is higher than that of the light emitting diode 1 with the quantum well structure, the quantum-dot-like structure 233 is formed using self-assembling techniques by heat treating the layer of GaInN series semiconductor material. As a result, the shapes and sizes of the quantum-dot-like structure 233 are formed at random and are likely to be completely different, and distribution density of the quantum-dot-like structure 233 cannot be controlled. According to research, the shape, size, and distribution density of the quantum-dot-like structure 233 that is capable of emitting light may influence the range of light wavelength and the luminous uniformity, and thus, the light emitting diode 2 is required to be further improved.

Therefore, an object of the present invention is to provide a method for making a solid state light emitting device that includes quantum clusters and that has high luminous efficiency and narrow range of light wavelength.

In addition, another object of the present invention is to provide a solid state light emitting device that includes quantum clusters and that has high luminous efficiency and narrow range of light wavelength.

According to a first aspect of the present invention, a method for making a solid state light emitting device comprises: (a) forming a first cladding layer composed of a first semiconductor material on a substrate; (b) forming a matrix layer above the first cladding layer opposite to the substrate, the matrix layer having a top surface and being formed with a plurality of isolated spaces; (c) epitaxially forming a quantum cluster in each of the spaces in the matrix layer such that the top surface of the matrix layer and top surfaces of the quantum clusters cooperatively define a coplanar surface, the quantum clusters cooperating with the matrix layer to forma light emitting layer; (d) forming a second cladding layer composed of a second (e.g., p-type) semiconductor material on the light emitting layer opposite to the first cladding layer; and (e) forming an electrode unit electrically connected to the first and second cladding layers to supply electricity to the light emitting layer.

According to a second aspect of the present invention, a method for making a solid state light emitting device comprises: (a) forming a first cladding layer composed of a first (e.g., n-type) semiconductor material on a substrate; (b) forming a quantum layer above the first cladding layer opposite to the substrate; (c) partially etching the quantum layer to form a plurality of through holes and a plurality of isolated quantum clusters each of which is spaced apart from an adjacent one of the quantum clusters by the through holes and has a top surface; (d) epitaxially forming a matrix layer in each of the through holes such that top surfaces of the matrix layer and top surfaces of the quantum clusters cooperatively define a coplanar surface, the matrix layers cooperating with the quantum clusters to form a light emitting layer; (e) forming a second cladding layer composed of a second (e.g., p-type) semiconductor material on the light emitting layer opposite to the first cladding layer; and (f) forming an electrode unit electrically connected to the first and second cladding layers to supply electricity to the light emitting layer.

According to a third aspect of the present invention, a solid state light emit ting device comprises: a substrate; a first cladding layer formed on the substrate and composed of a first (e,g., n-type) semiconductor material; a light emitting unit formed on the first cladding layer opposite to the substrate and having at least one light emitting layer, the light emitting layer including a matrix layer that has a top surface and formed with a plurality of isolated spaces, and a plurality of quantum clusters each of which is formed in a respective one of the isolated spaces of the matrix layer and has a top surface, the top surface of the matrix layer and the top surfaces of the quantum clusters cooperatively defining a coplanar surface; a second cladding layer formed on the light emitting unit opposite to the first cladding layer and composed of a second (e.g., p-type) semiconductor material; and an electrode unit electrically connected to the first and second cladding layers to supply electricity to the light emitting layer.

The advantage of the present invention is to provide a method for manufacturing a solid state light emitting device having quantum clusters that have similar sizes and shapes and regular distribution, thereby improving the internal quantum efficiency and light emission uniformity of the solid state light emitting device.

Other features and advantages of the present invention will become apparent in the following detailed description of the preferred embodiments of the invention, with reference to the accompanying drawings, in which:
Fig. 1 is a schematic diagram of a conventional solid state light emitting device including an active layer that has a quantum well structure;
Fig. 2 is a schematic diagram of another conventional solid state light emitting device including an active layer that has an irregular quantum-dot-like structure;
Fig. 3 is a flow chart illustrating a method for making the conventional solid state light emitting device shown in Fig. 2;
Fig. 4 is a schematic diagram of the preferred embodiment of a solid state light emitting device according to the present invention;
Fig. 5 is a flow chart illustrating a first method for making the preferred embodiment of the solid state light emitting device shown in Fig. 4;
Fig. 6 is a flow chart illustrating a second method for making the preferred embodiment of the solid state light emitting device shown in Fig. 4;
Fig. 7 shows a solid state light emitting device which is a modification of the light emitting device shown in Fig. 4, and which has merely one light emitting layer;
Fig. 8 is a flow chart illustrating a first method for making the preferred embodiment of the solid state light emitting device shown in Fig. 7; and
Fig. 9 is a flow chart illustrating a second method for making the preferred embodiment of the solid state light emitting device shown in Fig. 7.

Before the present invention is described in greater detail with reference to the accompanying preferred embodiments, it should be noted herein that like elements are denoted by the same reference numerals throughout the disclosure.

Unless otherwise defined, all technical and scientific terms used herein have the meaning commonly understood by a person skilled in the art to which this invention belongs. For clarity, as used herein, the term "quantum cluster" is a quasi-zero-dimensional semiconductormaterial, i. e. , abound state of an electron and hole, are confined in all three spatial dimensions and may include a plurality of quantum dots.

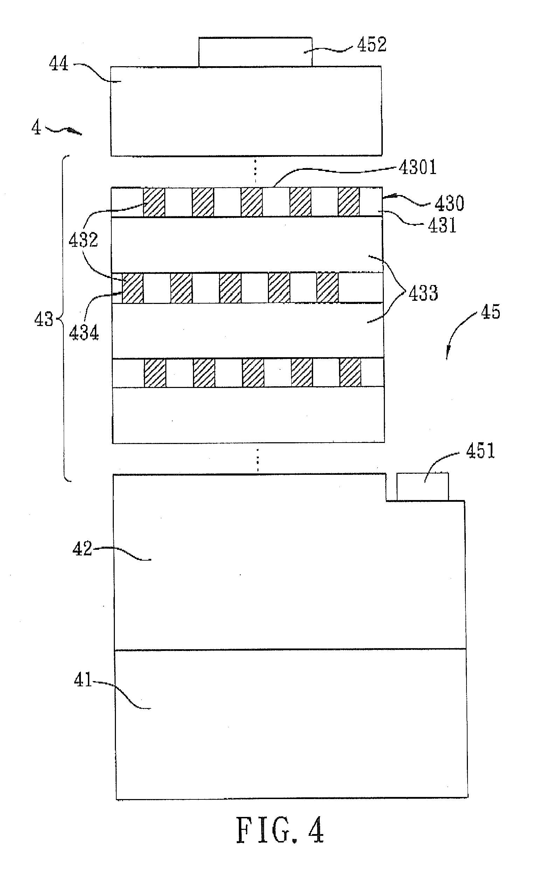

Referring to Fig. 4, the preferred embodiment of a solid state light emitting device of the present invention is a light emitting diode 4 that comprises a substrate 41, a first cladding layer 42, a second cladding layer 44, and a light emitting unit 43 disposed between the first and second cladding layers 42, 44, and an electrode unit 45 electrically connected to the first and second cladding layers 42, 44 and capable of electrically connected to an external circuit.

Preferably, the substrate 41 is made from a sapphire-based material.

The first cladding layer 42 is formed on a top surface of the substrate 41 and is composed of a first semiconductor material of GaN series compounds (n-type semiconductor material in the embodiment).

The second cladding layer 44 is formed on the light emitting unit 43 opposite to the first cladding layer 42.The material for the second cladding layer 44 is similar to that of the first cladding layer 42 and is a GaN series compound. However, the material for the second cladding layer 44 is a second semiconductor material (p-type semiconductor material in the embodiment).

The light emitting unit 43 is formed on the first cladding layer 42 opposite to the substrate 41 and includes a plurality of light emitting layers 430 each having a thickness not larger than 50nm, and a plurality of barrier layers 433 alternately disposed with the light emitting layers 430 for isolating adjacent ones of the light emitting layers 430. The barrier layer 433 and the light emitting layers 430 are respectively made of GaN series compounds. Each of the light emitting layers 430 includes a matrix layer 431 that has a top surface and that includes a plurality of isolated spaces 434, and a plurality of quantum clusters 432 each of which is embedded in the respective one of the isolated spaces 434 in the matrix layer 431 and has a top surface. Each of the spaces 434 in the matrix layer 431 has a substantially circular cross section with a diameter ranging from In to 10nm, has a depth ranging from 1nm to 10nm, and has a distribution density in the matrix layer 431 ranging from 1×10¹⁰ cm⁻² to 5×10¹³ cm⁻². The quantum clusters 432 are made of GaN series compounds and are capable of emitting light by transferring electricity energy into photon energy. The top surface of the matrix layer 431 and the top surfaces of the quantum clusters 432 cooperatively define a coplanar surface 4301. Preferably, the coplanar surface 4301 has a roughness not greater than 2nm. Since the quantum clusters 432 are embedded in the spaces 434 in the matrix layer 431, and since the spaces 434 have similar sizes and shapes and regular distribution, the quantum clusters 432 also have similar sizes and shapes and regular distribution. In other word, in this invention, each of the quantum clusters 432 of the light emitting layers 430 has an average diameter ranging from 1nm to 10nm and an average height ranging from 1nm to 10nm, and a distribution density of the quantum clusters 432 embedded in the matrix layer 431 ranges from 1×10¹⁰ cm⁻² to 5×10¹³ cm⁻². Therefore, the solid state light emitting device of this invention has relatively narrow range of light wavelength and improved luminous uniformity.

The electrode unit 45 includes a first electrode 451 connected to the first cladding layer 42 and a second electrode 452 connected to the second cladding layer 44, and is capable of providing external electricity to the light emitting unit 43.

When the light emitting diode 4 is connected to an external circuit, carriers, i.e., electrons and holes, from the first and second cladding layers 42, 44 are excited and confined in the quantum clusters 432 of the light emitting layers 430. Because the quantum clusters 433 are quasi-zero-dimensional and have similar sizes and regular distribution, the carriers are constrained in excited states with generally similar energies. Therefore, when the carriers recombine with each other in the light emitting layers 430, the light emitting layers 430 may release energy in the form of light having generally similar frequencies. In other words, the wavelength range of the light emitted from the light emitting diode 4 is narrowed, thereby improving the brightness of the light emitting diode 4. Moreover, since the structure of the quantum clusters 432 may enhance the recombination of the carriers, the efficiency of the light emitting diode 4 may be increased accordingly.

Two methods for making the aforesaid light emitting diode according to the present invention are described below to aid one skilled in the art in further understanding the scope and spirit of the present invention.

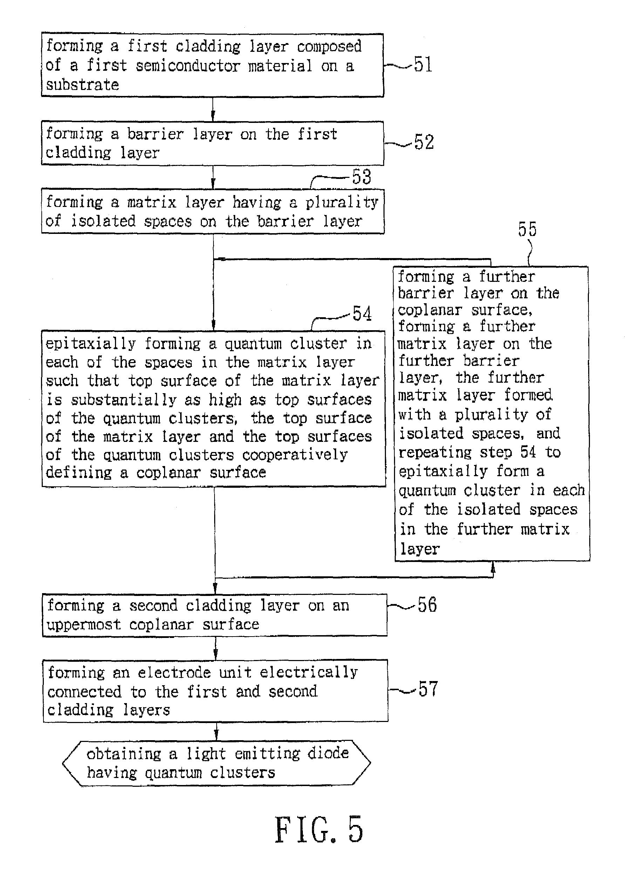

As shown in Figs. 4 and 5, the first method includes: forming a first cladding layer 42 on a substrate 41 (step 51); forming a barrier layer 433 on the first cladding layer 42 (step 52); forming a matrix layer 431 on the barrier layer 433 opposite to the substrate 41, the matrix layer 431 having a top surface and being formed with a plurality of isolated spaces 434 (step 53) ; epitaxially forming a quantum cluster 432 in each of the spaces 434 in the matrix layer 431 such that the top surface of the matrix layer 431 is substantially as high as top surfaces of the quantum clusters 432, the top surface of the matrix layer 431 and the top surfaces of the quantum clusters 432 cooperatively defining a coplanar surface 4301 that has a roughness not greater than 2nm, the quantum clusters 432 cooperating with the matrix layer 431 to form a light emitting layer 430 (step 54); forming a further barrier layer 433 on the coplanar surface 4301, forming a further matrix layer 431 on the further barrier layer 433, the further matrix layer 431 having a top surface and being formed with a plurality of isolated spaces 434, epitaxially forming a quantum cluster 432 in each of the isolated spaces 434 in the further matrix layer 431 by repeating step 54 (step 55); repeating step 55 to form a plurality of the light emitting layers 430 and a plurality of the barrier layers 433 which are alternately disposed and cooperatively define a light emitting unit 43; forming a second cladding layer 44 on the light emitting unit 43 (step 56); and forming an electrode unit 45 including a first electrode 451 and a second electrode 452 respectively and electrically connected to the first and second cladding layers 42, 44 (step 57). Preferably, each of the steps of the first method is conducted epitaxially.

Preferably, each of the light emitting layers 430 has a thickness not larger than 50nm, and each of the quantum clusters 432 of the light emitting layers 430 has a substantially round shape with a diameter ranging from 1nm to 10nm and a height ranging from 1nm to 10nm. The distribution density of the quantum clusters 432 in each of the light emitting layers 430 ranges from 1×10¹⁰ cm⁻² to 5×10¹³ cm⁻².

It should be noted that the epitaxially formed matrix layers 431 have substantially similar crystal structure and thus the distributions and sizes of the crystal defects thereof are substantially regular. Accordingly, the isolated spaces 434 formed in the matrix layers 431 are regularly distributed and have regular shapes and sizes. Thus, the quantum clusters 432 epitaxially formed in the spaces 434 are distributed regularly and have regular shapes and sizes, thereby resulting in a narrower wavelength range and improved light emission uniformity of the light emitting diode 4.

In the step (b) of the aforesaid first method of this invention, each of the isolated spaces 434 formed in the matrix layer 431 may have a depth smaller than or equal to the thickness of the matrix layer 431. The matrix layers 431 formed with the isolated spaces 434 can be produced by any techniques or processes known to one skilled in the art, such as etching the matrix layer 431 using a corrosive gas. Alternatively, the matrix layers 431 formed with the isolated spaces 434 can be produced_by way of reducing the growth temperature and increasing the growth rate of the epitaxial growth of the matrix layers 431. It should be noted that, when the etching process is used to form the isolated spaces 434, due to the naturally occurring crystal defects of the matrix layers 431, the etching process can be conducted without using a mask.

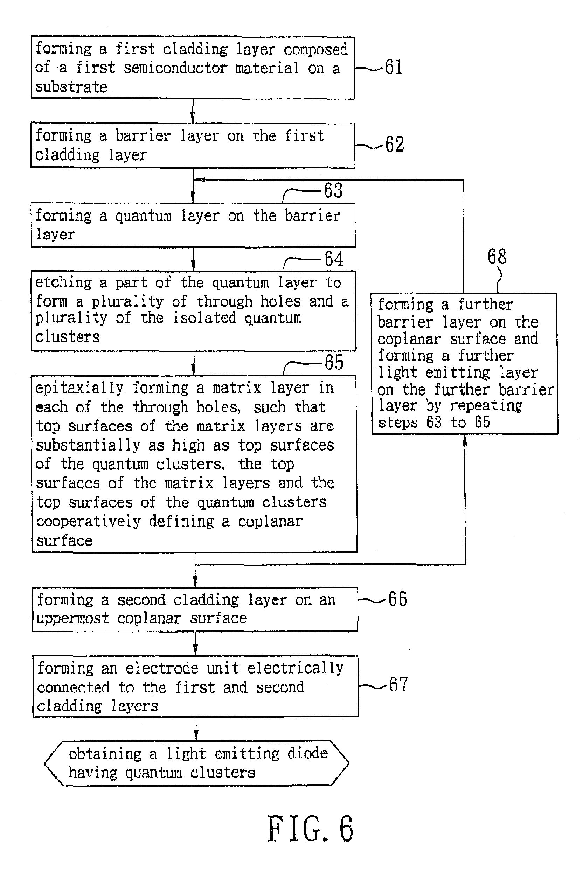

As shown in Figs. 4 and 6, the second method for making the aforesaid preferred embodiment of the solid state light emitting diode 4 according to the present invention includes: epitaxially forming the first cladding layer 42 on the substrate 41 (step 61); epitaxially forming the barrier layer 433 made of GaN series semiconductor materials on the first cladding layer 42 (step 52); forming a quantum layer on the barrier layer 433 opposite to the substrate 41 (step 63), the quantum layer being made of GaN series semiconductor materials and having a thickness ranging from 1nm to 10nm ; etching a part of the quantum layer from crystal defects thereof using a corrosive gas such as hydrogen or hydrochloric acid to form a plurality of through holes and a plurality of the isolated quantum clusters 432 each of which is spaced apart from an adjacent one of the quantum clusters 432 by the through holes and has a top surface (step 64); epitaxially forming the matrix layer 431 in each of the through holes, such that top surfaces of the matrix layers 431 are substantially as high as the top surfaces of the quantum clusters 432, the top surfaces of the matrix layers 431 and the top surfaces of the quantum clusters 432 cooperatively defining a coplanar surface 4301 that has a roughness not greater than 2nm and that is used to epitaxially forming subsequent layers, the quantum clusters 432 cooperating with the matrix layers 431 to form the light emitting layer 430 (step 65); forming a further barrier layer 433 on the coplanar surface 4301 and forming a further light emitting layer 430 on the further barrier layer 433 by repeating steps 63 to 65 in the specified order (step 68): repeating step 68 to form a plurality of the light emitting layers 430 and a plurality of the barrier layers 433 which are alternately disposed and cooperatively define the light emitting unit 43; forming the second cladding layer 44 on the light emitting unit 43 (step 66) ; and forming the electrode unit 45 electrically connected to the first and the second cladding layers 42, 44 (step 67).

Similar to the description above, since the epitaxially formed quantum layer has a regular structure and regularly distributed crystal defects, the quantum clusters 432 thus formed by etching the quantum layer may have regular distribution and regular shapes and sizes, thereby resulting in a narrower wavelength range and improved light emission uniformity of the light emitting diode 4.

In view of the above, the applicants provide methods for making the solid state light emitting device having a plurality of quantum clusters 432 that are regularly distributed and have regular shapes and sizes. With the quantum clusters 432 that are regularly distributed and have regular shapes and sizes, a narrower wavelength range and improved light emission uniformity can be achieved.

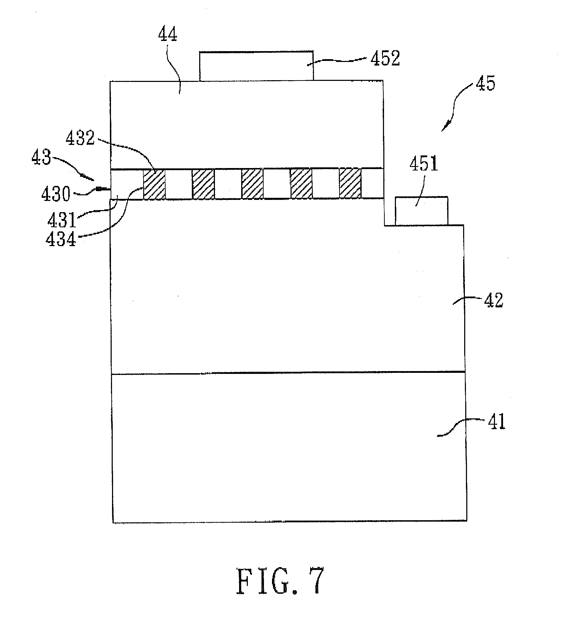

Fig. 7 shows a modification of the preferred embodiment of the solid state light emitting device according to the present invention, which has merely one light emitting layer 430 and no barrier layer. The solid state light emitting device shown in Fig, 7 has a relatively simple structure and is usually used in laboratories.

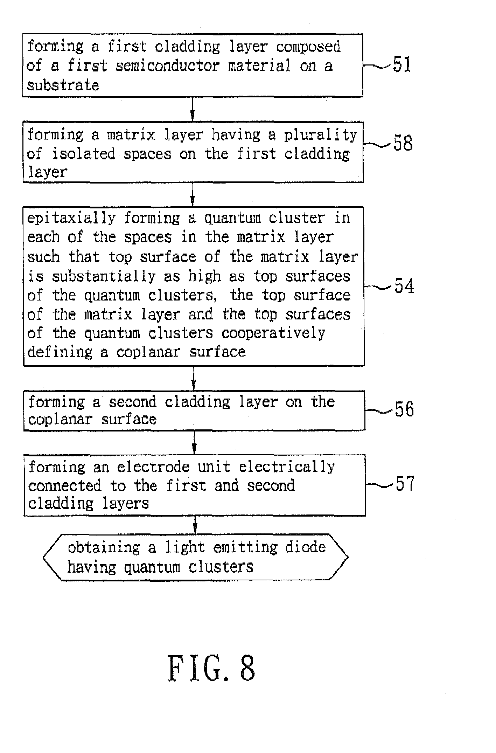

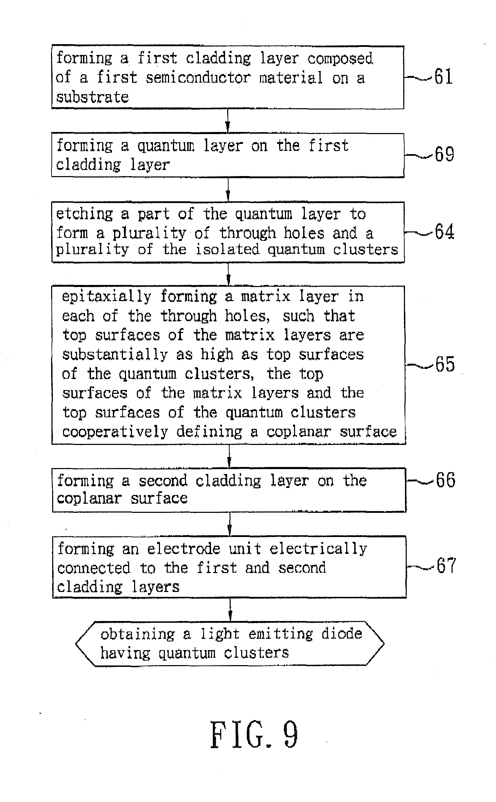

Figs. 8 and 9 respectively show first and second methods for making the solid state light emitting device having merely one light emitting layer 430. The methods shown in Fig. 8 and 9 are respectively similar to the methods shown in Fig. 5 and 6, except that the steps 52 and 55 in the first method and the steps 62 and 68 in the second method are respectively omitted in the method shown in Figs. 8 and 9. Accordingly, in step 58 of the first method shown in Fig. 8, the matrix layer 431 formed with a plurality of isolated spaces 434 is directed formed on the first cladding layer 42, and in step 69 of the second method shown in Fig. 9, the quantum layer is directed formed on the first cladding layer 42. Compared with the quantum-dot-like structure 233 of the light emitting diode 2 formed by heat treatment, the solid state light emitting diode 4 made by the aforesaid first or second methods of this invention has a relatively regular structure of quantum clusters 432, and the quantum clusters 432 have similar shapes and sizes and are uniformly distributed in the light emitting layer 430 of the solid state light emitting diode 4. Thus, the improved internal quantum efficiency and light emission uniformity, and a narrower wavelength range could be accomplished.

## Claims

1. A method for making a solid state light emitting device, **characterized by**:
(a) forming a first cladding layer (42) composed of a first semiconductor material on a substrate (41);
(b) forming a matrix layer (431) above the first cladding layer (42) opposite to the substrate (41), the matrix layer (431) having a top surface and being formed with a plurality of isolated spaces (434);
(c) epitaxially forming a quantum cluster (432) in each of the spaces (434) in the matrix layer (431) such that the top surface of the matrix layer (431) and top surfaces of the quantum clusters (432) cooperatively define a coplanar surface (4301), the quantum clusters (432) cooperating with the matrix layer (431) to form a light emitting layer (430);
(d) forming a second cladding layer (44) composed of a second semiconductor material on the light emitting layer (430) opposite to the first cladding layer (42) ; and
(e) forming an electrode unit (45) electrically connected to the first and second cladding layers (42, 44) to supply electricity to the light emitting layer (430).

2. The method of claim 1, **characterized in that**, in step (b), forming the matrix layer (431) is conducted by an epitaxial way and the matrix layer (431) has a thickness not larger than 50nm.

3. The method of claim 2, **characterized in that** each of the spaces (434) in the matrix layer (431) has a substantially, circular cross section with a diameter ranging from 1nm to 10nm, has a depth ranging from 1nm to 10nm, and has a distribution density in the matrix layer (431) ranging from 1×10¹⁰ cm⁻² to 5×10¹³ cm⁻² .

4. The method of claim 1, **characterized in that** the coplanar surface (4301) has a roughness not greater than 2nm.

5. The method of claim 1, further **characterized by**, between steps (c) and (d), a step (f) of forming a barrier layer (433) on the light emitting layer (430), and forming a further light emitting layer (430) on the barrier layer (433) by repeating steps (b) and (c) in the specified order.

6. The method of claim 4, further **characterized by**, between steps (c) and (d) , a step (f) of forming a barrier layer (433) on the light emitting layer (430), and forming a further light emitting layer (430) on the barrier layer (433) by repeating steps (b) and (c) in the specified order.

7. A method for making a solid state light emitting device, **characterized by**:
(a) forming a first cladding layer (42) composed of a first semiconductor material on a substrate (41);
(b) forming a quantum layer above the first cladding layer (42) opposite to the substrate (41);
(c) etching a part of the quantum layer to form a plurality of through holes and a plurality of isolated quantum clusters (432) each of which is spaced apart from an adjacent one of the quantum clusters (432) by the through holes and has a top surface;
(d) epitaxially forming a matrix layer (431) in each of the through holes, such that top surfaces of the matrix layers (431) and top surfaces of the quantum clusters (432) cooperatively define a coplanar surface (4301), the matrix layers (431) cooperating with the quantum clusters (432) to form a light emitting layer (430);
(e) forming a second cladding layer (44) composed of a second semiconductor material on the light emitting layer (430) opposite to the first cladding layer (42); and
(f) forming an electrode unit (45) electrically connected to the first and second cladding layers (42, 44) to supply electricity to the light emitting layer (430).

8. The method of claim 7, **characterized in that**, in step (b), forming the quantum layer (432) is conducted by an epitaxial way and the quantum layer (432) has a thickness ranging from 1nm to 10nm.

9. The method of claim 8, **characterized in that** each of the quantum clusters (432) has a substantially round shape with a diameter ranging from 1nm to 10nm and a height ranging from 1nm to 10nm, a distribution density of the quantum clusters (432) ranging from 1×10¹⁰ cm⁻² to 5×10¹³ cm⁻²

10. The method of claim 7, **characterized in that** the coplanar surface (4301) has a roughness not greater than 2 nm.

11. The method of claim 7, further **characterized by**, between steps (d) and (e), a step (g) of forming a barrier layer (433) on the light emitting layer (430) , and forming a further light emitting layer (430) on the barrier layer (433) by repeating steps (b), (c) , and (d) in the specified order.

12. The method of claim 10, further **characterized by**, between steps (d) and (e) , a step (g) of forming a barrier layer (433) on the light emitting layer (430) , and forming a further light emitting layer (430) on the barrier layer (433) by repeating steps (b) , (c) , and (d) in the specified order.

13. A solid state light emitting device, **characterized by**:
a substrate (41);
a first cladding layer (42) formed on said substrate (41) and composed of a first semiconductor material;
a light emitting unit (43) formed on said first cladding layer (42) opposite to said substrate (41) and having at least one light emitting layer (430), said light emitting layer (430) including a matrix layer (431) that has a top surface and formed with a plurality of spaces (434), and a plurality of quantum clusters (432) each of which is formed in a respective one of said spaces (434) of said matrix layer (431) and has a top surface, said top surface of said matrix layer (431) and said top surfaces of said quantum clusters (432) cooperatively defining a coplanar surface (4301);
a second cladding layer (44) formed on said light emitting unit (43) opposite to said first cladding layer (42) and composed of a second semiconductor material; and
an electrode unit (45) electrically connected to said first and second cladding layers (42, 44) to supply electricity to the light emitting layer (430).

14. The solid state light emitting device of claim 13, **characterized in that** said light emitting layer (430) has a thickness not larger than 50nm.

15. The solid state light emitting device of claim 14, **characterized in that** each of said spaces (434) in saidmatrix layer (431) has a substantially circular cross section with a diameter ranging from 1nm to 10nm, has a depth ranging from 1nm to 10nm, and has a distribution density in the matrix layer (431) ranging from 1×10¹⁰ cm⁻² to 5×10¹³ cm⁻².

16. The solid state light emitting device of claim 13, **characterized in that** said coplanar surface (4301) has a roughness not greater than 2nm.

17. The solid state light emitting device of claim 13, **characterized in that** said plurality of spaces (434) are separated from each other.

18. The solid state light emitting device of claim 13, **characterized in that** said plurality of quantum clusters (432) are separated from each other.
